# EUROPÄISCHE PATENTSCHRIFT

(11) **EP 0 793 860 B1**
(45) Veröffentlichungstag und Bekanntmachung des Hinweises auf die Patenterteilung: **30.05.2001**
(21) Anmeldenummer: 95937786.2
(22) Anmeldetag: 21.11.1995
(51) Int. Cl.: H01L 29/735, H01L 29/45

(54) **LATERALER BIPOLARTRANSISTOR**
LATERAL BIPOLAR TRANSISTOR
TRANSISTOR BIPOLAIRE LATERAL

(30) Priorität: 24.11.1994 DE 4441897
(43) Veröffentlichungstag der Anmeldung: 10.09.1997
(73) Patentinhaber: Infineon Technologies AG, 81669 München (DE)
(72) Erfinder: KERBER, Martin, D-81827 München (DE)
(74) Vertreter: Zedlitz, Peter, Dipl.-Inf.
(86) Internationale Anmeldenummer: DE9501623
(87) Internationale Veröffentlichungsnummer: WO9616446

(56) Entgegenhaltungen:
- EP-A- 0 168 125
- EP-A- 0 619 612
- 1991 SYMPOSIUM ON VLSI TECHNOLOGY DIGEST OF TECHNICAL PAPERS, 28. - 30.Mai 1991 OISO, JAPAN, Seiten 53-54, N. HIGAKI ET AL. 'A thin-base lateral bipolar transistor fabricated on bonded SOI'

## Beschreibung

Die vorliegende Erfindung betrifft einen lateralen Bipolartransistor insbesondere auf SOI-Substrat.

Bipolartransistoren sind ein wesentliches Bauelement bei integrierten Schaltkreisen auf SOI-Substrat, die im Rahmen eines BiCMOS-Prozesses hergestellt werden. Ein grundsätzliches Problem bei lateralen Bipolartransistoren ist der relativ hohe Anschlußwiderstand an die Basis. Bei lateraler Anordnung von Emitter, Basis und Kollektor ist die Basis ein schmaler Streifen zwischen Emitter und Kollektor. Dieser schmale Streifen muß üblicherweise an den Enden, d. h. lateral zu der Längsrichtung des Transistors, mittels eines hoch dotierten Anschlußbereiches kontaktiert werden. Bei dieser Struktur fließt der Basisstrom über die relativ hochohmige Basis. Der Schichtwiderstand der Basis ist durch die Randbedingungen begrenzt, die sich aus der geforderten Stromverstärkung ergeben. Als Schichtwiderstand ist kein besserer Wert als etwa 10 bis 20 kOhm/sq zu erreichen. Ein direkter niederohmiger Basisanschluß beispielsweise mittels auf den Basisbereich aufgebrachten Polysiliziums scheitert an der schnellen Diffusion des Dotierstoffes aus diesem Polysilizium in das Halbleitermaterial der Basis, wodurch die Ladungsträger in dem Basisbereich in unkontrollierbarer Weise beeinflußt würden. In der Veröffentlichung von T. Hori et. al. in IEEE Trans. Electron Devices 36, 340 - 350 (1989) und in der darin zitierten Literatur werden die elektrischen und physikalischen Eigenschaften von nitridierten Oxidschichten untersucht. In der Veröffentlichung von T. Morimoto et. al. in IEDM 90, 429 - 432 (1990) werden die Eigenschaften nitridierter Oxidschichten auf Silizium als Diffusionsbarriere für Bor beschrieben. Außerdem wird in der Veröffentlichung von N. Higaki et al. in Symposium on VLSI Technology, Digest of Technical Papers, 28.-30. Mai 1991, Oiso, JP, 53-54 ein lateraler Bipolartransistor beschrieben, der eine Spacer-Schicht aus SiN aufweist, die auf dem Basisbereich vorhanden ist.

Aufgabe der vorliegenden Erfindung ist es, einen insbesondere für Herstellung im Rahmen eines BiCMOS-Prozesses auf SOI-Substrat geeigneten lateralen Bipolartransistor, der über eine niederohmige Basiszuleitung verfügt, und ein Herstellungsverfahren dafür anzugeben.

Diese Aufgabe wird mit dem Bipolartransistor mit den Merkmalen des Anspruches 1 bzw. mit dem Verfahren mit den Merkmalen des Anspruches 5 gelöst. Weitere Ausgestaltungen ergeben sich aus den abhängigen Ansprüchen.

Bei dem erfindungsgemäßen Transistor wird eine niederohmige Basiszuleitung durch eine auf dem Basisbereich aufgebrachte Basis-Elektrode aus Polysilizium realisiert. Das Polysilizium ist für niedrigen Widerstand hoch dotiert. Durch eine Diffusionsbarriere, die sich zwischen dem eigentlichen Basisbereich und dieser Basis-Elektrode befindet, wird Diffusion von Dotierstoff aus der Elektrode in das Halbleitermaterial der Basis verhindert und gleichzeitig erreicht, daß ein ausreichend guter elektrischer Kontakt zwischen der Basis-Elektrode und dem Basisbereich des Transistors gewährleistet ist. Diese Diffusionsbarriere besteht z. B. aus Siliziumnitrid, das eine effiziente Barriere gegen Diffusion von Dotierstoff darstellt, ist aber so dünn, daß ein elektrischer Kontakt zwischen der Basis-Elektrode und dem Basisbereich vorhanden ist.

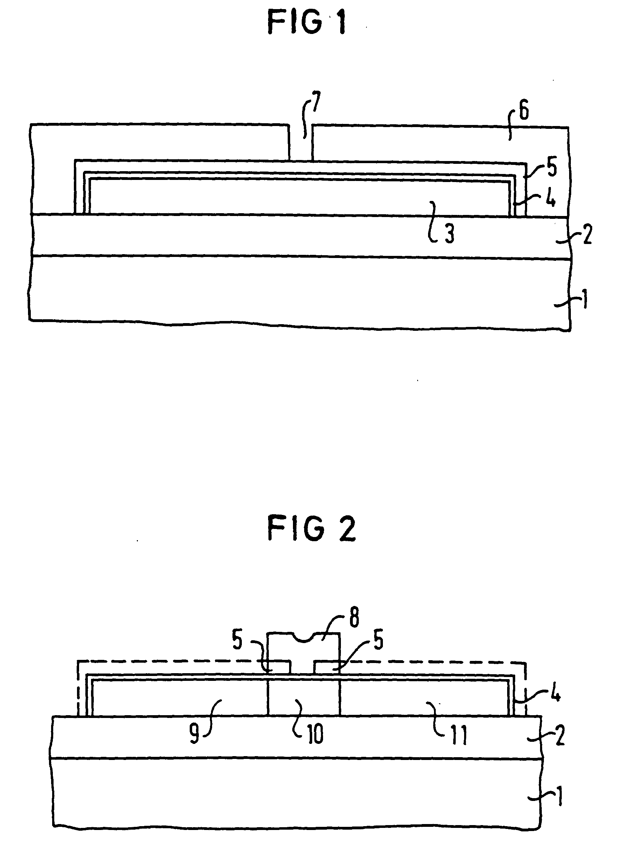

Es folgt eine Beschreibung des erfindungsgemäßen Bipolartransistors sowie dessen Herstellung anhand der Figuren 1 und 2, die Zwischenstufen des erfindungsgemäßen Transistors nach verschiedenen Schritten des Herstellungsverfahrens im Querschnitt zeigen.

Bei der Herstellung des erfindungsgemäßen Bipolartransistors wird wie üblich bis zur Herstellung der Dotierung für den Basisbereich verfahren. In Figur 1 ist der für den Transistor vorgesehene Bereich als Beispiel durch eine Mesa 3 als Rest einer Nutzschicht aus Silizium (sog. Body-Siliziumschicht) auf einer Isolatorschicht 2 auf einer Bulk-Siliziumschicht 1 eines SOI-Substrates gegeben. Statt einer Mesa 3 kann auch ein ringsum z. B. mittels LOCOS elektrisch isolierter Bereich vorgesehen sein. Dieser Bereich, d. h. in dem beschriebenen Beispiel die Mesa 3, wird mit einer für den Basisbereich vorgesehenen Dotierung versehen. Dann wird die Diffusionsbarriere 4 als dünne Schicht hergestellt. Das geschieht z. B. dadurch, daß entsprechend dem von T. Hori beschriebenen Verfahren zunächst eine dünne Oxidschicht (maximal ca. 10 nm) aufgebracht wird und dann in einer stickstoffhaltigen Atmosphäre an der Grenzfläche dieser Oxidschicht 5 zur Mesa 3 aus Silizium eine dünne Siliziumnitridschicht (typischerweise etwa 2 nm) hergestellt wird. Eine solche Diffusionsbarriere 4 aus Siliziumnitrid ist besonders geeignet, um die Diffusion von Dotierstoff aus Polysilizium der herzustellenden Basis-Elektrode in das Silizium einer Body-Siliziumschicht, in der der laterale Bipolartransistor hergestellt wird, zu verhindern.

Mittels einer Maske 6 (z. B. eine Lackmaske) mit einer Öffnung 7 im Bereich der herzustellenden Basis-Elektrode wird das restliche Oxid der Oxidschicht 5 entfernt, so daß hier die Oberfläche der Diffusionsbarriere 4 freigelegt ist. Bei naßchemischem Ätzen der Oxidschicht 5 bleibt wegen der hohen Selektivität gegen Nitrid die Diffusionsbarriere 4 praktisch in voller Dicke erhalten. In diese Öffnung der Oxidschicht wird dann Polysilizium abgeschieden und anschließend strukturiert entsprechend der Figur 2, in der die aus dem Polysilizium strukturierte Basis-Elektrode 8 mit Resten der Oxidschicht 5 dargestellt ist. Die ursprüngliche Abmessung der Oxidschicht 5 ist gestrichelt eingezeichnet. Beim Strukturieren der Basis-Elektrode 8 dient die Oxidschicht 5 als Ätzstopp. Die Basis-Elektrode 8 kann dann als Maske für die Implantierung der Dotierstoffe für den Emitterbereich 9 und den Kollektorbereich 11 dienen.

Das Polysilizium der Basis-Elektrode wird so strukturiert, daß sich lateral ein größerer Anschlußbereich aus Polysilizium, der mit der Basis-Elektrode 8 verbunden ist, befindet. In diesen Anschlußbereich wird unter Verwendung einer Maske, die den eigentlichen Transistor, d. h. insbesondere den Emitterbereich 9 und den Kollektorbereich 11 abdeckt, Dotierstoff implantiert, wobei die Dosis so hoch gewählt wird, daß eine niederohmige Zuleitung aus einem auf diesen Anschlußbereich aufgebrachten Kontakt in die Basis-Elektrode 8 ermöglicht ist und daß außerdem in einem Temperschritt zum Aktivieren des Dotierstoffes so viel Dotierstoff in die Basis-Elektrode 8 aus dem Anschlußbereich ausdiffundiert, wie für eine niederohmige Zuleitung in den Basisbereich 10 erforderlich ist. Die Basis-Elektrode 8 ist dann für den Leitungstyp des Basisbereichs 10 dotiert. Bei der Aktivierung der Dotierstoffe verhindert die Diffusionsbarriere 4 zwischen der Basis-Elektrode 8 und dem Basisbereich 10 das weitere Diffundieren des Dotierstoffes aus dem Polysilizium der Basis-Elektrode in das Silizium des Basisbereiches 10. Die Diffusionsbarriere 4 ist aber so dünn, daß die Ladungsträger nahezu ungehindert von der Basis-Elektrode 8 in den Basisbereich 10 gelangen können (Tunneleffekt), womit ein kleiner Basis-Zuleitungswiderstand gegeben ist.

## Patentansprüche

1. Lateraler Bipolartransistor mit einem Emitterbereich (9), einem Basisbereich (10) und einem Kollektorbereich (11) in einer Halbleiterschicht und mit einem Basis-Anschlußbereich, **dadurch gekennzeichnet,**
daß auf diesem Basisbereich (10) eine davon durch eine Diffusionsbarriere (4) getrennte Basis-Elektrode (8) aus dotiertem Polysilizium vorhanden ist,
daß diese Diffusionsbarriere (4) so dünn ist, daß Ladungsträger in einem für die Funktion des Transistors ausreichenden Ausmaß diese Diffusionsbarriere durch Tunneleffekt passieren können, und daß diese Basis-Elektrode (8) mit diesem Basis-Anschlußbereich elektrisch leitend verbunden ist.

2. Bipolartransistor nach Anspruch 1,
bei dem die Halbleiterschicht monokristallines Silizium ist.

3. Bipolartransistor nach Anspruch 2,
bei dem die Halbleiterschicht eine Body-Siliziumschicht eines SOI-Substrates ist.

4. Bipolartransistor nach einem der Ansprüche 1 bis 3,
bei dem die Diffusionsbarriere (4) Nitrid ist.

5. Verfahren zur Herstellung eines Bipolartransistors nach Anspruch 2 und 4 mit den folgenden Schritten:
a) Ein für den Bipolartransistor vorgesehener Bereich wird mit einer für den Basisbereich (10) vorgesehenen Dotierung versehen und mit einer Oxidschicht (5) bedeckt;
b) in einer stickstoffhaltigen Atmosphäre wird an der Grenzfläche zwischen dieser Oxidschicht (5) und der Halbleiterschicht eine Nitridschicht (4) hergestellt;
c) unter Verwendung einer Maske (6) wird in einem für die Basis-Elektrode (8) vorgesehenen Bereich ein Rest der Oxidschicht entfernt;
d) eine für die Basis-Elektrode (8) vorgesehene Schicht aus Polysilizium wird aufgebracht und so strukturiert, daß ein für den Basis-Anschlußbereich vorgesehener Anteil und ein für die Basis-Elektrode (8) vorgesehener Anteil, die miteinander verbunden sind, übrigbleiben und daß der für den Basisbereich (10) vorgesehene Bereich von Polysilizium bedeckt ist;
e) unter Verwendung von Masken werden Implantierungen von Dotierstoffen für den Emitterbereich (9) und den Kollektorbereich (11) sowie für den Basis-Anschlußbereich eingebracht;
f) die eingebrachten Dotierstoffe werden aktiviert und eine Diffusion des in das Polysilizium eingebrachten Dotierstoffes aus dem Basis-Anschlußbereich in die Basis-Elektrode (8) bewirkt.

6. Verfahren nach Anspruch 5, bei dem
in Schritt a) die Oxidschicht (5) in einer Dicke von höchstens 10 nm aufgebracht wird und
in Schritt b) die Nitridschicht in einer Dicke von höchstens 2 nm hergestellt wird.

## Claims

1. Lateral bipolar transistor having an emitter region (9), a base region (10) and a collector region (11) in a semiconductor layer and having a base terminal region, characterized
in that there is present, on the said base region (10), a base electrode (8) which is made of doped polysilicon material and is separated from the said base region by a diffusion barrier (4),
in that the said diffusion barrier (4) is thin enough to enable charge carriers to pass through the said diffusion barrier by a tunnel effect to a degree which suffices for the functioning of the transistor and
in that the said base electrode (8) is electrically conductively connected to the said base terminal region.

2. Bipolar transistor according to Claim 1,
in which the semiconductor layer is monocrystalline silicon.

3. Bipolar transistor according to Claim 2,
in which the semiconductor layer is a body silicon layer of an SOI substrate.

4. Bipolar transistor according to one of Claims 1 to 3,
in which the diffusion barrier (4) is nitride.

5. Method for producing a bipolar transistor according to Claims 2 and 4, having the following steps:
a) a region which is provided for the bipolar transistor is provided with a doping envisaged for the base region (10) and is covered with an oxide layer (5);
b) a nitride layer (4) is produced in a nitrogen-containing atmosphere at the interface between the said oxide layer (5) and the semiconductor layer;
c) using a mask (6), a residue of the oxide layer is removed in a region provided for the base electrode (8);
d) a polysilicon layer provided for the base electrode (8) is applied and is structured in such a way that a portion which is provided for the base terminal region and a portion which is provided for the base electrode (8), which portions are connected to one another, remain and that the region provided for the base region (10) is covered by polysilicon;
e) using masks, implantations of dopants for the emitter region (9) and the collector region (11) and also for the base terminal region are made;
f) the dopants which have been introduced are activated and diffusion of the dopant which has been introduced into the polysilicon out of the base terminal region into the base electrode (8) is effected.

6. Method according to Claim 5, in which
in step a) the oxide layer (5) is applied to a thickness of at most 10 nm, and
in step b) the nitride layer is produced with a thickness of at most 2 nm.

## Revendications

1. Transistor bipolaire latéral avec une zone d'émetteur (9), une zone de base (10) et une zone de collecteur (11) dans une couche semi-conducteur et avec une zone de raccordement de la base
**caractérisé par le fait**
que, sur cette zone de base (10), se trouve une électrode de base (8) en polysilicium dopé, séparée de cette zone de base par une barrière de diffusion (4), que cette barrière de diffusion (4) est si mince que des porteurs de charge peuvent traverser, d'une manière suffisante pour la fonction du transistor, cette barrière de diffusion, grâce à un effet de tunnel, et
que cette électrode de base (8) est raccordée électriquement à cette zone de raccordement de la base.

2. Transistor bipolaire selon la revendication 1
sur lequel la couche de semi-conducteur est du silicium monocristallin.

3. Transistor bipolaire selon la revendication 2
sur lequel la couche de semi-conducteur est une couche body de silicium d'un substrat SOI ou en silicium sur isolateur.

4. Transistor bipolaire selon l'une des revendications 1 à 3
sur lequel la barrière de diffusion (4) est du nitrure.

5. Procédé pour la production d'un transistor bipolaire selon la revendication 2 et 4 avec les étapes suivantes:
a) une zone prévue pour le transistor bipolaire est recouverte d'un dopage prévu pour la zone de base (10) et d'une couche d'oxyde (5);
b) dans une atmosphère à teneur d'azote, une couche de nitrure (4) est produite sur la surface limite entre cette couche d'oxyde (5) et la couche semi-conducteur;
c) en utilisant un masque (6), un reste de la couche d'oxyde est enlevé sur une zone prévue pour l'électrode de base (8);
d) une couche en polysilicium, prévue pour l'électrode de base (8), est mise en place et structurée de telle façon qu'il reste une partie prévue pour la zone de raccordement de la base et une partie prévue pour l'électrode de base (8), qui sont reliées l'une à l'autre, et que la zone prévue pour la zone de base (10) est recouverte de polysilicium;
e) en utilisant des masques, on applique des implantations de produit de dopage pour la zone de l'émetteur (9) et la zone du collecteur (11), ainsi que pour la zone de raccordement de la base;
f) on active les produits de dopage mis en place et on provoque une diffusion du produit de dopage placé dans le polysilicium, à partir de la zone de raccordement de la base dans l'électrode de base (8).

6. Procédé selon la revendication 5 au cours duquel
au cours de l'étape a), on applique la couche d'oxyde (5) avec une épaisseur d'un maximum de 10 nm et
au cours de l'étape b), on produit la couche de nitrure avec une épaisseur d'un maximum de 2 nm.
